# EUROPÄISCHE PATENTSCHRIFT

(11) **EP 0 411 036 B1**
(45) Veröffentlichungstag und Bekanntmachung des Hinweises auf die Patenterteilung: **07.01.1993**
(21) Anmeldenummer: 89905408.4
(22) Anmeldetag: 28.04.1989
(51) Int. Cl.: C04B 41/88, C04B 35/10

(54) **KERAMISCHE PLATTE (SUBSTRAT), DIE WENIGSTENS EINSEITIG MIT METALL BESCHICHTET IST**
CERAMIC PLATE (SUBSTRATE) COATED ON AT LEAST ONE SIDE WITH METAL
PLAQUE CERAMIQUE (SUBSTRAT) AVEC REVETEMENT DE METAL SUR UNE FACE AU MOINS

(30) Priorität: 29.04.1988 DE 3814486
(43) Veröffentlichungstag der Anmeldung: 06.02.1991
(73) Patentinhaber: DODUCO GMBH + Co Dr. Eugen Dürrwächter, 75172 Pforzheim (DE)
(72) Erfinder: WAIBEL, Brigitte, D-7530 Pforzheim (DE); MARTIN, Wolfram, D-7534 Birkenfeld (DE); BUNGE, Hans-Joachim, D-3392 Clausthal-Zellerfeld (DE)
(74) Vertreter: Twelmeier, Ulrich, Dipl.Phys.
(86) Internationale Anmeldenummer: EP8900470
(87) Internationale Veröffentlichungsnummer: WO8910339

(56) Entgegenhaltungen:
- Journal of the American Ceramic Society, Band 58, Nrs. 9-10, September-Oktober 1975 (US) Y. Nakada et al.: "Surface texture formation in Al2O3 substrates" Seiten 409-412, siehe Zusammenfassung; Seite 410, Spalte 1, Zeilen 23-41; Seite 410, Spalte 2, Zeilen 2-25; Tabelle 1
- Journal of the American Ceramic Society, Band 65, Nr. 3, März 1982 (US) M. Wittmer et al.: "Mechanical properties of liquid-phase-bonded copper-ceramic substrates" Seiten 149-153, siehe Zusammenfassung
- Chemical Abstracts, Band 93, Nr. 10, September 1980, (Columbus, Ohio, US) E. Bessenyei et al.: "Change of the mechanical properties of thin ceramic tapes as a function of the conditions of preparation", siehe Seite 315, Zusammenfassung Nr. 100372m & Magy. Kem. Foly. 1980, 86(4), 185-91

## Beschreibung

Die Erfindung geht aus von einer keramischen Platte, die wenigstens einseitig mit Metall beschichtet ist, insbebesondere von einer solchen Platte, die aus einem Werkstoff mit hexagonaler Kristallstruktur besteht. Ein üblicher keramischer Werkstoff mit hexagonaler Kristallstruktur ist Aluminiumoxid.

Dünne Aluminiumoxidplatten, die mindestens einseitig, vor allem aber beidseitig mit je einer Metallplatte bedeckt sind, finden beispielsweise als Wärmesenken für elektronische Leistungsbauelemente Verwendung. Dabei gibt es Einsatzbedingungen, z.B. bei der Verwendung in Zündvorrichtungen für Ottomotoren in Automobilen, für welche die mit Metall beschichteten keramischen Platten eine hohe Temperaturwechselbeständigkeit aufweisen müssen. Infolge unterschiedlicher Wärmeausdehnungskoeffizienten des keramischen Werkstoffs und Ces Metalls bewirken Temperaturwechsel entsprechend wechselnde Zug- und Druckspannungen in der keramischen Platte parallel zu ihrer mit dem Metall beschichteten Oberfläche. Bei unzureichender Temperaturwechselbeständigkeit können die Temperaturwechsel zu einem Bruch in der Keramikplatte parallel zu ihrer Oberfläche führen (Muschelbruch). Die Gefahr eines solchen Bruchs ist dann besonders groß, wenn sich der keramische Werkstoff und das Metall in ihrem Wärmeausdehnungskoeffizienten besonders stark unterscheiden. Das ist insbesondere dann der Fall, wenn ein gut wärmeleitendes Metall wie Kupfer direkt, d.h. ohne eine Zwischenschicht aus einem anderen Metall oder aus einer Metallegierung, mit der Keramikplatte verbunden wird. Eine Zwischenschicht, die eine gute Duktilität aufweist, z.B. eine Zwischenschicht aus einer Lotlegierung, könnte die auftretenden Wärmespannungen nämlich teilweise ausgleichen.

Aus dem Journal of the American Ceramic Society, Vol. 58, Nr. 9-10 Seiten 409-412, Sep.-Oct. 1975 ist bereits ein Al₂O₃-Substrat offenbart, welches eine relative Texturstärke, gemessen an der Polfigur 006 von 0-3 besitzt. Es ist ferner offenbart, dass die Sintertemperatur einen Einfluß auf die Textur hat. Das Journal of the American Ceramic Society, Vol 65, Nr. 3, Seiten 149-158, März 1982 beschreibt eine metallbeschichtete Keramikplatte und deren Verwendung in der Leistungselektronik, dass Temperaturwechselbeständigkeit von metallbeschichteten keramischen Platten durch Wärmespannungen beeinträchtigt ist. Die Temperaturwechselbeständigkeit soll danach durch Wahl eines besonderen Beschichtungsverfahrens verbessert werden.

Der Erfindung liegt die Aufgabe zugrunde, bei keramischen Platten (Substraten) der eingangs genannten Art die Temperaturwechselbeständigkeit zu verbessern.

Für keramische Platten aus einem Werkstoff mit hexagonaler Kristallstruktur wird diese Aufgabe mit den im Anspruch 1 angegebenen Merkmalen gelöst.

Die Erfinder haben herausgefunden, dass dünne keramische Platten abhängig von ihrem Herstellungsverfahren eine unterschiedlich stark ausgeprägte Textur haben und dass die Temperaturwechselbeständigkeit einer solchen keramischen Platte, wenn sie wenigstens einseitig, insbesondere wenn sie beidseitig mit Metall beschichtet ist, um so besser ist, je weniger ausgeprägt die Textur des keramischen Werkstoffs ist. Die Temperaturwechselbeständigkeit ist am besten, wenn der Werkstoff überhaupt keine Textur aufweist, seine Kristallite also statistisch völlig regellos orientiert sind. Die technische Lehre dieses Patentes gibt dem Fachmann eine Auswahlregel für die keramischen Platten an die Hand. Bei Verwendung eines keramischen Werkstoffes mit hexagonaler Kristallstruktur - Beispiele sind Aluminiumoxid und Aluminiumnitrid - soll für die keramische Platte ein Werkstoff gewählt werden, bei dem die relative Texturstärke bei der (006)-Polfigur kleiner als 5 ist. Im Beispiel des Aluminiumoxids sollte die relative Texturstärke bei der (006)-Polfigur zweckmässigerweise kleiner als 4,5, vorzugsweise kleiner als 3 sein. Das beste Ergebnis im Hinblick auf die Temperaturwechselbeständigkeit kann der Fachmann erwarten, wenn er eine Keramik auswählt, deren Textur so gering wie technisch möglich ist; im Idealfall hat die Keramik überhaupt keine Textur.

Wie man die Textur analysieren und zahlenmässig bestimmen kann, ist dem Fachmann bekannt, einen Überblick darüber gibt H.-J. Bunge in seiner Veröffentlichung "Three dimensional texture analysis", International Materials Reviews 1987, Vol. 32, No. 6, 265-291. Zum Verständnis der Texturanalyse sei an dieser Stelle folgendes gesagt:

Ein Werkstoff hat eine kristallographische Textur, wenn die Kristallite, aus denen er besteht, nicht regellos orientiert sind, sondern eine Vorzugsorientierung aufweisen. Die Orientierung eines einzelnen Kristalliten in einer Probe des Werkstoffes wird durch die Drehung festgelegt, die das Koordinatensystem seiner Kristallachsen in das Koordinatensystem der Probe überführt. Ist die Probe wie im vorliegenden Fall eine Platte, wählt man als Koordinatensystem der Probe zweckmässigerweise die Längsrichtung, die Querrichtung und die Normalrichtung der Platte. Die Drehung g wird durch drei Winkel festgelegt, vorzugsweise durch die drei Euler-Winkel φ₁, φ, φ₂. Die Textur ist dann als Häufigkeitsverteilung (Orientation Distribution Function (ODF) ) der Kristallite bezüglich ihrer kristallographischen Orientierung (φ₁, φ, φ₂) definiert.

Die Texturmessung erfolgt vornehmlich durch Röntgenbeugung; in besonderen Fällen verwendet man auch Neutronenbeugung und Elektronenbeugung. Dabei wird die räumliche Winkelverteilung einzelner ausgewählter Kristallrichtungen gemessen. Diese Winkelverteilungen heißen "Polfiguren" (pole figures). Eine einzelne Polfigur beschreibt die Textur nicht vollständig, da sie nur von jeweils zwei von insgesamt drei Orientierungsparametern abhängt; die Polfigur ist lediglich eine zweidimensionale Projektion der räumlichen (dreidimensionalen) Häufigkeitsverteilung der Kristallite bzw. ihrer kristallographischen Orientierung. Aus mehreren unterschiedlichen zweidimensionalen Projektionen der Häufigkeitsverteilung, also aus mehreren unterschiedlichen Polfiguren, kann die räumliche (dreidimensionale) Häufigkeitsverteilung der kristallographischen Orientierungen in der Probe, also die vollständige Orientierungsverteilungsfunktion (ODF),berechnet werden. Die Berechnung erfolgt mit dem mathematischen Verfahren der Polfigur-Inversion.

Aus der Orientierungsverteilungsfunktion (ODF) können beliebige Polfiguren zurückberechnet werden, auch solche Polfiguren, die nur schwer oder gar nicht meßbar sind, weil der zugehörige Reflex im Röntgenbeugungsbild nur eine geringe Intensität hat. Bei den Werkstoffen mit hexagonaler Kristallstruktur, mit denen sich diese Erfindung befaßt, trifft das zum Beispiel für den Basisreflex (006) zu. Also für die Beugung von Röntgenstrahlen an den mit den Miller-Indizes (006) gekennzeichneten Netzebenen des Kristallgitters. Die (006)-Polfigur, auch Basispolfigur genannt, ist daher röntgenographisch meßbar; sie kann aber durch Analyse der Orientierungsverteilungsfunktion (ODF) aus anderen meßbaren Polfiguren berechnet werden, insbesondere aus den sechs Polfiguren (012), (104), (110), (113), (116) und (024). Dazu wird auf die oben angegebene Veröffentlichung von H-J. Bunge verwiesen.

Im vorliegenden Fall ist die Textur bezogen auf die Orientierung der hexagonalen Basisfläche der Kristallite in dem Werkstoff mit hexagonaler Kristallstruktur angegeben worden, weil sich gezeigt hat, dass diese kristallographische Basisfläche bevorzugt parallel zur Substratoberfläche liegt. Als Texturstärke wird daher im vorliegenden Fall die relative Intensität im Maximum der Häufigkeitsverteilung der Kristallite in der (006)-Polfigur angegeben, und zwar wird sie angegeben als relative Texturstärke, indem die Intensität im Maximum der Häufigkeitsverteilung ausgedrückt wird in Vielfachen der Intensität bei regelloser Orientierung. Die auf die (006)-Polfigur bezogene relative Texturstärke gibt deshalb an, um welchen Faktor die Kristallite mit ihrer (006)-Basisfläche im Maximum der Orientierungsverteilung häufiger anzutreffen sind, als sie es bei einer regellosen Orientierung, d.h. bei einem Werkstoff ohne Textur, wären. Die Stärke der Textur kann man zeichnerisch in steriographischer Projektion darstellen. Bei einer solchen Kugelprojektion kommt als variable Größe die Lage einer bestimmten, an sich beliebig wählbaren kristallographischen Fläche, im vorliegenden Fall der hexagonalen Basisfläche, zur Abbildung. In der Kugelprojektion werden allerdings nicht die ausgewählten kristallographischen Flächen selbst abgebildet, sondern. deren Normalen, die "Flächenpole" genannt werden. Die Abbildung geschieht in der Weise, dass man sich ein jedes Kristallit, dessen Orientierung untersucht werden soll, im Zentrum einer Kugel angeordnet vorstellt und die Normale (den Flächenpol) der kristallographischen Fläche, deren Orientierung bestimmt werden soll, dadurch in der Äquatorialebene der Kugel abbildet, dass man den Punkt, in welchem die Normale die Kugelfläche durchstößt, mit dem Südpol der Kugel verbindet. Die Abbildung der Normalen (Flächenpole) der ausgewählten Kristallfläche (im vorliegenden Fall die hexagonale Basisfläche) der Gesamtheit der Kristallite einer Platte bildet die Polfigur. In der Polfigur äußert sich eine Vorzugsrichtung in der Orientierung der Flächenpole darin, dass die Dichte bzw. Häufigkeit der Punkte, die die Polfigur bilden, an einer für die Platte charakteristischen Stelle in der Polfigur ein Maximum hat. Der Zahlenwert der relativen Texturstärke wird dadurch gebildet, dass man in der Polfigur dieses Maximum aufsucht und die Intensität an der Stelle dieses Maximums, für die die Dichte bzw. Häufigkeit der dort liegenden Punkte der abgebildeten Flächenpole ein Maß ist, vergleicht mit der Dichte bzw.

Häufigkeit von Punkten, die durch Abbildung der entsprechenden Flächenpole einer Platte mit gleicher Zusammensetzung, aber ohne Textur, auf dieselbe Stelle der Äquatorialebene erzeugt worden sind; mit anderen Worten: die relative Texturstärke gibt die Textur eines Werkstoffes an, wobei die Texturstärke für die vollständig regellose Verteilung der Kristallite zu 1 normiert ist.

Die Erfinder haben erkannt, dass man die Temperaturwechselbeständigkeit keramischer Platten aus einem Werkstoff mit hexagonaler Kristallstruktur wesentlich verbessern kann, wenn die Texturstärke bestimmte Grenzwerte nicht überschreitet. Der Zusammenhang zwischen der Temperaturwechselbeständigkeit und der Texturstärke wird nachstehend anhand einiger experimenteller Ergebnisse beleuchtet:
Es wurden Aluminiumoxidkeramikplatten mit den Maßen
- Länge: 23,2 mm
- Breite: 13,2 mm
- Dicke: 0,635 mm

mit Kupferplatten mit den Maßen
- Länge: 21,0 mm
- Breite: 11,0 mm
- Dicke: 0,65 mm

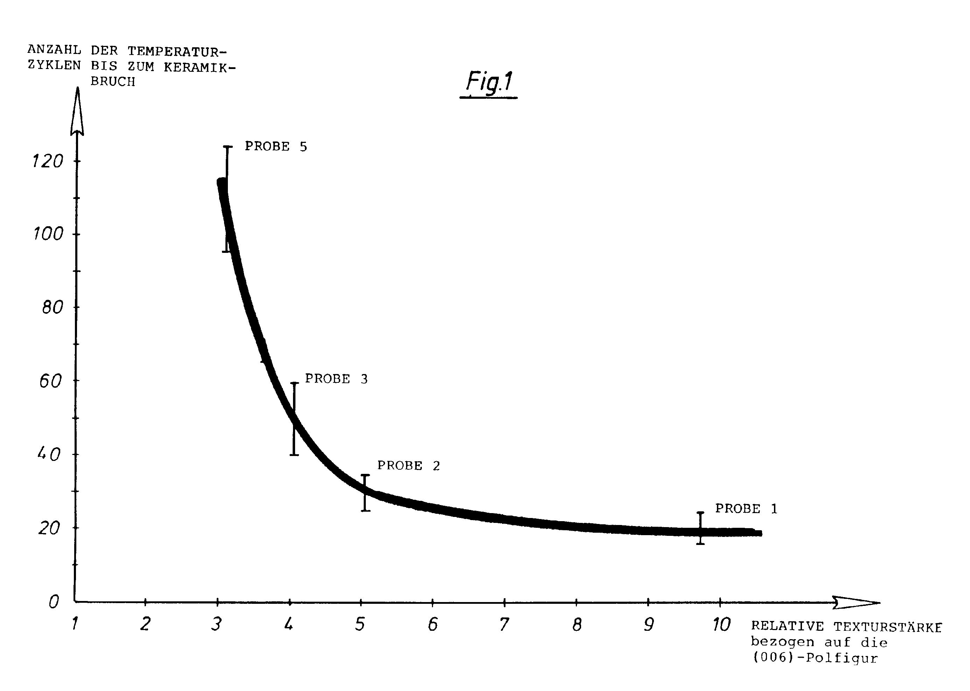

im "Direct-Bonding"-Verfahren beschichtet. Eine größere Anzahl von Prüflingen wurde einer Temperaturwechselbeanspruchung zwischen -40° C und +110° C unterworfen, wobei die Prüflinge jeweils 40 Minuten lang bei der unteren und bei der oberen Temperatur gehalten wurden und binnen einer Umlagerzeit von höchstens 10 s zwischen der unteren und der oberen Temperatur umgelagert wurden. Es wurde bestimmt, wie viele solcher Temperaturzyklen ein jeder Prüfling aushält, bis die keramische Platte bricht. Die beobachtete Zahl der Temperaturzyklen bis zum Keramikbruch wurde in Beziehung gesetzt zu der zuvor aus der (006)-Polfigur (sie bildet bei den untersuchten Aluminiumoxidkeramikplatten konzentrische Kreise) bestimmten Texturstärke der keramischen Platten. Das Ergebnis ist in der beigefügten Fig. 1 in Form einer Kurve dargestellt, die die Temperaturzyklenzahl bis zum Keramikbruch in Abhängigkeit von der Texturstärke zeigt. Man sieht, dass die Temperaturwechselbeständigkeit mit abnehmender Texturstärke ansteigt, wobei dieser Anstieg unterhalb einer relativen Texturstärke von 4,5 besonders ausgeprägt ist und bei einer relativen Texturstärke von 3,5 zu einer schon rund 4 mal so hohen Temperaturwechselbeständigkeit führt wie bei einer Platte mit ausgeprägter Textur (siehe Probe 1 mit einer relativen Texturstärke von 9,75).

Die in Fig. 1 bezeichneten Proben 1 und 2 mit einer relativen Texturstärke von 9,75 bzw. 5,05 hatten Aluminiumoxidplatten, die nach dem Foliengießverfahren hergestellt waren. Bei diesem Verfahren wird eine wässrige Aufschlämmung (Schlicker) eines Aluminiumoxidpulvers auf ein laufendes Band gegossen,und durch Wärmeeinwirkung getrocknet, so dass ein zusammenhängendes Band entsteht. Aus diesem Band werden Platten ausgestanzt, geschichtet, beschwert und zu festen Platten gesintert.

Die in Fig. 1 so bezeichneten Proben 3 und 5 wurden nach dem Verfahren des Walzverdichtens hergestellt. Dazu wird ein Aluminiumoxidpulver mit einem Bindemittel vermischt und anschließend sprühgetrocknet, das getrocknete Pulver in den Walzspalt eines Walzwerks gegeben, und dabei zu einem Band gewalzt. Aus dem Band werden Platten ausgestanzt, geschichtet, beschwert und gesintert.

Die Untersuchungen zeigen, dass das Verfahren des Walzverdichtens ein für Zwecke der Erfindung geeignetes Verfahren ist. Ein anderes für Zwecke der Erfindung geeignetes Verfahren zur Herstellung von keramischen Platten mit verbesserter Temperaturwechselbeständigkeit besteht darin, ein Aluminiumoxidpulver und ein Bindemittel miteinander zu vermischen, zu trocknen, insbesondere durch Sprühtrocknen, das getrocknete Pulver in eine Preßform zu füllen, in welcher daraus plattenförmige Rohlinge gepreßt werden, die anschließend durch Sintern verfestigt werden.

Die Erfindung ist nicht nur anwendbar auf keramische Platten aus einem Werkstoff mit hexagonaler Kristallstruktur, sondern auch auf andere Keramiken, beispielsweise auf Platten aus Berylliumoxid, welches eine kubische Kristallstruktur hat.

## Patentansprüche

1. Keramische Platte (Substrat) aus einem Werkstoff mit
hexagonaler Kristallstruktur, die wenigstens einseitig mit Metall beschichtet ist, dadurch gekennzeichnet,
daß die relative Texturstärke der Keramik bei der (006)-Polfigur kleiner als 5 ist.

2. Platte nach Anspruch 1, dadurch gekennzeichnet,
daß der keramische Werkstoff Aluminiumoxid ist und daß die relative Texturstärke bei der (006)-Polfigur kleiner als 4,5, vorzugsweise kleiner als 3,5 ist.

3. Keramische Platte (Substrat), die wenigstens einsei-
tig mit Metall beschichtet ist, dadurch gekennzeichnet,
daß die Keramik keine Textur hat, so daß ihre Kristallite statistisch regellos orientiert sind.

## Claims

1. A cermaic plate (substrate) which consists of a material having a hexagonal crystal structure and is-coated with metal at least on one side, characterized in that the relative degree of texture of the ceramic in the (006)-pole figure is less than 5.

2. A plate according to claim 1, characterized in that the ceramic material is alumina and the relative degree of texture in the (006)-pole figure is less than 4.5, preferably less than 3.5.

3. A ceramic plate (substrate), which is coated with metal at least on one side, characterized in that ceramic has no texture so that its crystallites have a random orientation.

## Revendications

1. Plaque céramique (substrat) constituée d'un matériau présentant une structure cristalline hexagonale et munie d'un revêtement de métal sur une face au moins, **caractérisée en ce** que l'intensité de texture relative de la céramique dans la figure de pôles (006) est inférieure à 5.

2. Plaque selon la revendication 1, caractérisée en ce que la matière céramique est de l'oxyde d'aluminium, et que l'intensité de texture relative dans la figure de pôles (006) est inférieure à 4,5 et de préférence inférieure à 3,5.

3. Plaque céramique (substrat) avec revêtement de métal sur une face au moins, caractérisée en ce que la céramique ne présente pas de texture, de sorte que ses cristallites ont une orientation statistiquement aléatoire.
